# EUROPÄISCHE PATENTSCHRIFT

(11) **EP 0 596 169 B1**
(45) Veröffentlichungstag und Bekanntmachung des Hinweises auf die Patenterteilung: **08.07.1998**
(21) Anmeldenummer: 92310174.5
(22) Anmeldetag: 06.11.1992
(51) Int. Cl.: H03H 7/075, H03H 7/03, H03H 9/58, H03H 9/52

(54) **Herstellungsverfahren und Schaltungsanordnung für ein schmalbandiges Filter hoher Güte**
Method of manufacture and circuit arrangement for a narrow band filter with a high quality factor
Circuit et procédé pour la fabrication d'un filtre à bande étroite et haut facteur de qualité

(43) Veröffentlichungstag der Anmeldung: 11.05.1994
(73) Patentinhaber: SIEMENS AKTIENGESELLSCHAFT, 80333 München (DE)
(72) Erfinder: Eynöthen, Peter, W-4290 Bocholt (DE); Wewers, Otger, W-4290 Bocholt (DE); Smith, Chris N., Romsey, Hampshire S051 7RP (GB)

(56) Entgegenhaltungen:
- US-A- 3 185 943
- ALTA FREQUENZA Bd. XLIV, Nr. 8, August 1975, MILANO IT BECCARI 'on the synthesis of lossy ladder filters'
- ELECTRONICS LETTERS. Nr. 16, August 1991, ENAGE GB Seiten 1456 - 1457 ,
- XP259872 LU 'design of symmetrical polylithic crystal filters having equal motional inductances'

## Beschreibung

Die Erfindung betrifft ein Herstellungsverfahren und eine Schaltungsanordnung für ein schmalbandiges Filter hoher Güte gemäß dem Oberbegriff der Patentansprüche 1 und 3.

Schmalbandige Filter hoher Güte, z. B. als Quarzfilter ausgebildete Zwischenfrequenzfilter, werden insbesondere dort eingesetzt, wo Frequenzanteile bei der Analogsignalübertragung für ein Einkanal- oder Mehrkanalsystem unterdrückt werden müssen. Ein solcher Fall liegt beispielsweise bei der Schnurlos-Kommunikation nach dem CT1+ Standard vor. Bei der Schnurlos-Kommunikation eines nach diesem Standard betriebenen Schnurlos-Kommunikationssystems, bestehend aus mindestens einer Mobilstation und Basisstation, wird für die Übertragungsrichtung "Mobilstation -- Basisstation" ein MS/BS-Analogsignal mit einer MS/BS-Signalfrequenz von 886 MHz und für die Übertragungsrichtung "Basisstation -- Mobilstation" ein BS/MS-Analogsignal mit einer BS/MS-Signalfrequenz von 931 MHz übertragen. Für den jeweiligen Empfang der mit diesen Signalfrequenzen übertragenen Analogsignale ist in einer jeweiligen Empfangseinrichtung (der Basisstation für die MS-BS Übertragungsrichtung und der Mobilstation für die BS-MS Übertragungsrichtung) jeweils ein Mischer vorgesehen, der von einem Oszillator gesteuert, aus dem jeweils empfangenen Analogsignal mit der diesem zugeordneten Signalfrequenz ein erstes und zweites Ausgangssignal erzeugt. Das erste Ausgangssignal weist dabei eine Frequenz auf, die sich aus der Summe der Signalfrequenz des Analogsignales und einer Oszillatorfrequenz eines Oszillatorsignales ergibt. Das zweite Ausgangssignal, das auch als Arbeitssignal des Zwischenfrequenzfilters bzw. Quarzfilters bezeichnet wird, weist eine Frequenz auf, die sich aus der absoluten Differenz zwischen der Signalfrequenz des Analogsignales und der Oszillatorfrequenz des Oszillatorsignales ergibt. Dieses zweite Ausgangssignal oder Arbeitssignal des Zwischenfrequenzfilters bzw. Quarzfilters entsteht in bezug auf das Oszillatorsignal mit der Oszillatorfrequenz für das jeweils übertragene Analogsignal mit der Signalfrequenz von 886 bzw. 931 MHz und einem weiteren Signal mit einer Spiegelfrequenz, die sich durch "Spiegelung" des Frequenzabstandes zwischen der Signalfrequenz des Analogsignals und des Oszillatorsignals ergibt. Von diesen beiden Signalen enthält nur das Analogsignal die jeweils von der Mobilstation bzw. Basisstation übertragene Information. Für die eingangs erwähnte Übertragungsrichtung "Basisstation -- Mobilstation" bedeutet dies, daß das Analogsignal mit der Signalfrequenz von 931 MHz bezogen auf das Oszillatorsignal mit der Oszillatorfrequenz von 989 MHz als Informationsträger dient und daß zu diesem Analogsignal (Trägersignal) bezogen auf die Oszillatorfrequenz das weitere Signal mit der Spiegelfrequenz unterdrückt werden muß. Um bei den hochfrequenten Analogsignalen eine ausreichende Unterdrückung der Signale mit den Spiegelfrequenzen zu erreichen, ist eine hohe Mittenfrequenz (Arbeitsfrequenz) des Arbeitssignales des Zwischenfrequenzfilters bzw. Quarzfilters erforderlich. Im vorliegenden Fall liegt diese Arbeitsfrequenz bei ca. 58 MHz. Dieser Wert ergibt sich daraus, daß die absolute Differenz der Oszillatorfrequenz von 989 MHz zur Trägerfrequenz von 931 MHz des Trägersignals = 58 MHz ist. Da bei der Schnurlos-Kommunikation nach dem CT1+-Standard darüber hinaus mehrere Kanäle für die Informationsübertragung zur Verfügung stehen und diese Kanäle einen Kanalabstand gemaß dem CT1+-Standard von 25 kHz aufweisen, muß außerdem sichergestellt werden, daß keine Analogsignale von Nachbarkanälen bezogen auf den jeweiligen Übertragungskanal mit übertragen werden. Um diese beiden Kriterien zu erfüllen, muß das Zwischenfrequenzfilter bzw. Quarzfilter scharfkantig (mit einer hohen Güte) ausgebildet sein. Mit einem solchen Filter hoher Güte lassen sich dann auch Forderungen bezüglich einer geringen Welligkeit des Übertragungsverhaltens im Durchlaßbereich (+/- 7,5 kHZ) erfüllen.

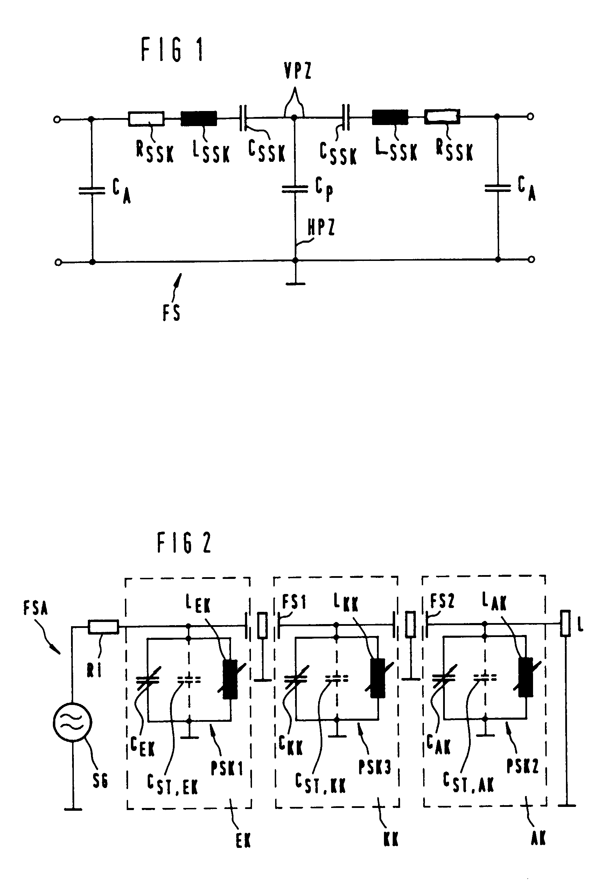

Figur 1 zeigt das Ersatzschaltbild einer als Quarzfilter ausgebildeten Filterschaltung FS. Die Filterschaltung FS ist dabei als Vierpol dargestellt, der symmetrisch zu einer in einem Hauptparallelzweig HPZ angeordneten Parallelkondensator C_{P} in zwei Vierpolzweigen VPZ, die mit dem Hauptparallelzweig HPZ eine T-Anordnung bilden, jeweils einen Serienkreis SSK, bestehend aus einem Widerstand R_{SSK}, einer Spule L_{SSK} und einem Kondensator C_{SSK}, aufweist. Darüber hinaus ist an beiden Ausgängen der als Vierpol dargestellten Filterschaltung FS jeweils in Parallelschaltung zu einem Gesamtschwingkreis, bestehend aus dem Serienschwingkreis SSK und dem Parallelkondensator C_{P}, jeweils ein Abschlußkondensator C_{A} angeordnet. Der Abschlußkondensator C_{A} berücksichtigt dabei z. B. verschiedene die Filtercharakteristik der Filterschaltung FS beeinträchtigende parasitare Stör-/Streukapazitäten.

Um diese parasitären Stör-/Streukapazitäten zu eliminieren, wird die Filterschaltung FS nach Figur 1 zu einer Filterschaltungsanordnung FSA nach Figur 2 ausgebaut. Die Filterschaltungsanordnung FSA ist dabei, um die eingangs beschriebenen Verhaltnisse beim Empfang des Analogsignals in der Basis- bzw. Mobilstation des Schnurlos-Kommunikationssystems prinzipiell darzustellen, eingangsseitig an einen Signalgenerator SG mit einem Innenwiderstand Ri und ausgangsseitig an eine Last (Verbraucher) L angeschlossen. Die Filterschaltungsanordnung FSA enthalt beispielsweise eine erste Filterschaltung FSl und eine zweite Filterschaltung FS2, die in Reihe zueinander geschaltet sind. Der ersten Filterschaltung FS1 ist ein zu der Filterschaltung FS1 parallel geschalteter erster Parallelschwingkreis PSK1 zugeordnet, der mit der ersten Filterschaltung FS1 einen Eingangskreis EK bildet. Der zweiten Filterschaltung FS2 ist ein zu dieser parallel geschalteter zweiter Parallelschwingkreis PSK2 zugeordnet, der mit der zweiten Filterschaltung FS2 einen Ausgangskreis AK bildet. Darüber hinaus ist beiden Filterschaltungen FS1, FS2 ein zu diesen beiden parallel geschalteter dritter Parallelschwingkreis PSK3 zugeordnet, der mit den beiden Filterschaltungen FS1, FS2 einen Koppelkreis KK bildet. Die zu den Filterschaltungen FS1, FS2 parallel geschalteten Parallelschwingkreise PSK1...PSK3 sind erforderlich, um die in den Abschlußkondensatoren C_{A} der Filterschaltungen FS1, FS2 jeweils berücksichtigten Stör-/Streukapazitäten (entsprechend der Darstellung in Figur 1) zu kompensieren. Um darüber hinaus in dem Eingangskreis EK, den Koppelkreis KK und den Ausgangskreis AK weitere parasitäre physikalische Größen, wie z. B. Leitungsreaktanzen (Leitungskapazitäten, Leitungsinduktivitäten), kompensieren zu können, sind in den Parallelschwingkreisen PSK1...PSK3 für den Parallelschwingkreis PSK1 des Eingangskreises EK1 neben einem Eingangskreiskondensator C_{EK} und einer Eingangskreisspule L_{EK} ein Streueingangskreiskondensator C_{ST}, _{EK} für den Parallelschwingkreis PSK3 des Koppelkreises KK neben einem Koppelkreiskondensator C_{KK} und einer Koppelkreisspule L_{KK} ein Streukoppelkreiskondensator C_{ST}, _{KK} und für den Parallelschwingkreis PSK2 des Ausgangskreises AK neben einer Ausgangskreiskapazität C_{AK} und einer Ausgangskreisspule L_{AK} ein Streuausgangskreiskondensator C_{ST}, _{AK} vorgesehen. Um die in Figur 2 dargestellte Filterschaltungsanordnung 2 für die vorstehend beschriebenen Bedingungen (Schmalbandigkeit, hohe Güte) optimal abgleichen zu können, war es bisher üblich, die in den Parallelschwingkreisen PSK1...PSK3 angeordneten Kondensatoren und Spulen als veränderbare Bauelemente auszubilden. Für eine optimal eingestellte Filtercharakteristik der Filterschaltungsanordnung FSA sind daher in der Fertigung aufwendige und teure Abgleichprozeduren notwendig.

Aus der Druckschrift Alta Frequenza Bd. XLIV, Nr. 8, August 1975, Milano, Seiten 446-453 (C. Beccari ,,On The Synthesis Of Lossy Ladder Filters") sind Herstellungsverfahren für Filter bzw. Filterschaltungen bekannt, bei denen die Verluste in den Bauelementen der Filterschaltungen kompensiert werden.

Aufgabe der Erfindung ist es, ein Herstellungsverfahren und eine Schaltungsanordnung für ein schmalbandiges Filter hoher Güte anzugeben, bei dem keinerlei Abgleichprozeduren durchzuführen sind.

Diese Aufgabe wird ausgehend von dem in dem Oberbegriff des Patentanspruches 1 definierten Herstellungsverfahren durch die in dem kennzeichnenden Teil des Patentanspruches 1 angegebenen Merkmale sowie ausgehend von der in dem Oberbegriff des Patentanspruches 5 definierten Schaltungsanordnung durch die in den kennzeichnenden Teil des Patentanspruches 5 angegebenen Merkmale gelöst.

Vorteilhafte Weiterbildungen der Erfindung sind in den Unteransprüchen angegeben.

Die Erfindung besteht darin, daß die in der Figur 1 und 2 dargestellten Leitungsverbindungen mit einer Meßanordnng ausgemessen werden und dann bei der Auswahl der in den Parallelschwingkreisen PSK1...PSK3 eingesetzten Kondensatoren und Spulen berücksichtigt werden. Durch dieses Verfahren ist es möglich, daß keine veränderbaren Kondensatoren, Spulen mehr in den Parallelschwingkreisen PSK1...PSK3 notwendig sind (keine Abgleichpunkte bzw. -prozeduren).

## Patentansprüche

1. Herstellungsverfahren für ein schmalbandiges Filter hoher Güte, bei dem dem Filter eine Filterschaltung (FS1, FS2) und eine Kompensationsfilterschaltung (PSK1...PSK3) zugeordnet werden, wobei der Filterschaltung (FS1, FS2) und der Kompensationsfilterschaltung (PSK1...PSK3) mehrere, die Filtercharakteristik bestimmende Bauelemente zugeordnet werden und bei dem die Bauelemente der Filterschaltung (FS1, FS2) und der Kompensationsfilterschaltung (PSK1...PSK3) miteinander verbunden werden,
**dadurch gekennzeichnet**,
daß die Verbindungen zwischen den Bauelementen in bezug auf die Filtercharakteristik beeinflussende parasitäre physikalische Störgrößen ausgemessen werden und daß die mit dem Ausmessen ermittelten Störgrößen beim Aufbau der Kompensationsfilterschaltung (PSK1...PSK3) mit den dieser zugeordneten Bauelementen berücksichtigt werden.

2. Herstellungsverfahren nach Anspruch 1,
**dadurch gekennzeichnet**,
daß Streukapazitäten oder Streuinduktivitäten als die die Filtercharakteristik beeinflussende parasitäre physikalische Störgröße ausgemessen werden.

3. Herstellungsverfahren nach Anspruch 1 oder 2,
**dadurch gekennzeichnet**,
daß der Kompensationsfilterschaltung (PSK1...PSK3) ausschließlich Bauelemente mit einem fest vorgegebenen Wert für eine dem Bauelement zugewiesene physikalische Größe zugeordnet werden.

4. Herstellungsverfahren nach Anspruch 3,
**dadurch gekennzeichnet**,
daß die Kapazität, die Induktivität oder der Widerstand als die physikalische Größe dem Bauelement der Kompensationsfilterschaltung (PSK1...PSK3) zugewiesen wird.

5. Schaltungsanordnung für ein schmalbandiges Filter hoher Güte, mit mindestens einer Filterschaltung (FS1, FS2) und mindestens einer Kompensationsfilterschaltung (PSK1...PSK3), wobei der Filterschaltung (FS1, FS2) und Kompensationsfilterschaltung (PSK1...PSK3) jeweils mehrere, miteinander verbundene, die Filtercharakteristik bestimmende Bauelemente zugeordnet sind,
**dadurch gekennzeichnet**,
daß die Bauelemente der Kompensationsfilterschaltung (PSK1...PSK3) als unveränderbare Bauelemente ausgebildet sind, bei denen durch das Ausmessen der Verbindungen zwischen den Bauelementen ermittelte, die Filtercharakteristik beeinflussende parasitäre physikalische Störgrößen berücksichtigt sind.

6. Schaltungsanordnung nach Anspruch 5,
**dadurch gekennzeichnet**,
daß die Filterschaltung (FS1, FS2) als Quarzfilter ausgebildet ist.

7. Schaltungsanordnung nach Anspruch 5 oder 6,
**dadurch gekennzeichnet**,
daß die Kompensationsfilterschaltung (PSK1...PSK3) als Parallelschwingkreis ausgebildet ist.

## Claims

1. Manufacturing method for a high-quality narrowband filter, in which the filter is assigned a filter circuit (FS1, FS2) and a compensation filter circuit (PSK1...PSK3), the filter circuit (FS1, FS2) and the compensation filter circuit (PSK1...PSK3) being assigned a plurality of components which determine the filter characteristic, and in which the components of the filter circuit (FS1, FS2) and of the compensation filter circuit (PSK1...PSK3) are connected to one another, characterized in that the connections between the components are measured with respect to the parasitic physical interference variables which influence the filter characteristic, and in that the interference variables which are determined by means of the measurement are taken into account in the design of the compensation filter circuit (PSK1...PSK3) by means of the components assigned to said circuit (PSK1...PSK3).

2. Manufacturing method according to Claim 1, characterized in that the parasitic physical interference variable influencing the filter characteristic is the leakage capacitances or leakage inductances.

3. Manufacturing method according to Claim 1 or 2, characterized in that the compensation filter circuit (PSK1...PSK3) is exclusively assigned components with a permanently prescribed value for a physical variable allocated to the component.

4. Manufacturing method according to Claim 3, characterized in that the physical variable which is assigned to the component of the compensation filter circuit (PSK1...PSK3) is the capacitance, the inductance or the resistance.

5. Circuit arrangement for a high-quality narrowband filter, having at least one filter circuit (FS1, FS2) and at least one compensation filter circuit (PSK1...PSK3), the filter circuit (FS1, FS2) and compensation filter circuit (PSK1...PSK3) each being assigned a plurality of components which are connected to one another and which determine the filter characteristic, characterized in that the components of the compensation filter circuit (PSK1...PSK3) are designed as unchangeable components, in which parasitic physical interference variables which have been determined by means of the measurement of the connections between the components and which influence the filter characteristic are taken into account.

6. Circuit arrangement according to Claim 5, characterized in that the filter circuit (FS1, FS2) is designed as a quartz filter.

7. Circuit arrangement according to Claim 5 or 6, characterized in that the compensation filter circuit (PSK1...PSK3) is designed as a parallel oscillatory circuit.

## Revendications

1. Procédé de fabrication d'un filtre à bande étroite ayant un haut facteur de qualité, dans lequel
un circuit de filtrage (FS1, FS2) et un circuit de filtrage de compensation (PSK1 à PSK3) sont associés au filtre, plusieurs composants déterminant la caractéristique de filtrage étant associés au circuit de filtrage (FS1, FS2) et au circuit de filtrage de compensation (PSK1 à PSK3), et dans lequel les composants du circuit de filtrage (FS1, FS2) et du circuit de filtrage de compensation (PSK1 à PSK3) sont reliés entre eux,
caractérisé par le fait qu'on mesure les liaisons entre les composants pour ce qui concerne des grandeurs physiques parasites influençant la caractéristique de filtrage et qu'on prend en compte les grandeurs physiques parasites déterminées par la mesure lors de la conception du circuit de filtrage de compensation (PSK1 à PSK3) avec les composants associés à celui-ci.

2. Procédé de fabrication selon la revendication 1,
caractérisé par le fait qu'on mesure des capacités de dispersion ou des inductances de dispersion en tant que grandeurs physiques parasites influençant la caractéristique de filtrage.

3. Procédé de fabrication selon la revendication 1 ou 2,
caractérisé par le fait qu'on n'associe au circuit de filtrage de compensation (PSK1 à PSK3) que des composants ayant une valeur prédéterminée constante pour une grandeur physique attribuée au composant.

4. Procédé de fabrication selon la revendication 3,
caractérisé par le fait qu'on attribue au composant du circuit de filtrage de compensation (PSK1 à PSK3) la capacité, l'inductance ou la résistance en tant que grandeur physique.

5. Montage pour un filtre à bande étroite ayant un haut facteur de qualité, comportant au moins un circuit de filtrage (FS1, FS2) et au moins un circuit de filtrage de compensation (PSK1 à PSK3), plusieurs composants qui déterminent la caractéristique de filtrage et qui sont reliés entre eux étant associés à chaque fois au circuit de filtrage (FS1, FS2) et au circuit de filtrage de compensation (PSK1 à PSK3),
caractérisé par le fait que les composants du circuit de filtrage de compensation (PSK1 à PSK3) sont conçus sous forme de composants non variables pour lesquels des grandeurs physiques parasites influençant la caractéristique de filtrage et déterminées par la mesure des liaisons entre les composants sont prises en compte.

6. Montage selon la revendication 5,
caractérisé par le fait que le circuit de filtrage (FS1, FS2) est conçu sous forme de filtre à quartz.

7. Montage selon la revendication 5 ou 6,
caractérisé par le fait que le circuit de filtrage de compensation (PSK1 à PSK3) est conçu sous forme de circuit oscillant parallèle.
